# EUROPEAN PATENT APPLICATION

(11) **EP 2 617 864 A2**
(43) Date of publication of application: **24.07.2013**
(21) Application number: 11825485.3
(22) Date of filing: 16.09.2011
(51) Int. Cl.: C23C 14/35, C23C 14/08, C23C 14/58

(54) **METHOD FOR IMPROVING HYDROPHILICITY OF A COATING FILM THROUGH TREATMENT ON A SURFACE MORPHOLOGY AND SUPER HYDROPHILIC GLASS COATING LAYER PRODUCED BY THE METHOD**

(30) Priority: 17.09.2010 KR 20100091975
(71) Applicant: LG Hausys, Ltd., Seoul 150-721 (KR)
(72) Inventor: CHO, Keum-Shil, Daejeon 305-340 (KR); LEE, Dong-Il, Anyang-si Gyeonggi-do 431-761 (KR); BAE, Il-Joon, Daejeon 302-752 (KR)
(74) Representative: Zacco Denmark A/S
(86) International application number: PCT/KR2011/006888
(87) International publication number: WO 2012/036525

(57) **Abstract**

The present disclosure provides a method of improving hydrophilicity of a coating layer through surface morphology treatment and a super-hydrophilic glass coating layer produced using the same. The method includes forming a photocatalyst layer on a substrate; and heating the substrate having the photocatalyst layer formed thereon to a temperature of 500°C to 600°C to perform post-heat treatment, and increasing surface roughness of the photocatalyst layer. The photocatalyst layer has a surface contact angle of 30 degrees or less.

## Description

### [Technical Field]

The present invention relates to a method of improving hydrophilicity of a coating layer through surface morphology treatment and a super-hydrophilic glass coating layer produced using the same, and more particularly, to a technology of performing super-hydrophilic coating to secure a clean appearance of a building or outdoor advertisement while facilitating maintenance of the building or outdoor advertisement through natural purification.

### [Background Art]

In recent years, window glass having good transmittance is applied to a building to secure field of view and natural lighting while finishing the building. However, due to such high transmittance of the window glass, contaminants attached to the window glass can be easily recognized, thereby deteriorating aesthetics of the outer appearance or reducing transmittance in the case where contaminants are severely attached to the window glass.

To solve such disadvantages, various attempts have been made to apply a special coating layer to a glass surface in order to maintain a clean outer appearance. In particular, hydrophilic coating has been suggested in that it can provide natural purification of contaminants with rain.

Thus, hydrophilic coating is performed on a glass substrate to finish an exterior of a building. In the related art, a hydrophilic coating glass is coated with a photocatalytic material on the surface thereof to realize hydrophilicity under conditions of UV irradiation.

However, when the hydrophilic coating glass is applied to the exterior of a building in practice, hydrophilic characteristics do not appear as in experimental data due to inconstant intensity of sunlight and low intensity of UV light.

Thus, coating layers based on fractal structure theory have been proposed to exhibit hydrophilic characteristics even under conditions of non-UV irradiation.

However, the coating layer based on fractal structure theory is subjected to wet coating, such as spraying, dipping, and slitting.

Since such wet coating has technical difficulty securing uniform quality of a coating layer in production of a large area coating layer, wet coating is generally directly performed upon a glass window attached to a building.

However, even in this case, since it is difficult to properly manage quality during in-field construction, the coating layer is deteriorated in durability over time. Moreover, the coating layer provides a foggy surface and makes it difficult to secure a transparent outer appearance.

### [Disclosure]

### [Technical Problem]

An aspect of the present invention is to provide a method of improving hydrophilicity of a coating layer through surface morphology treatment, in which heat treatment is performed at an optimized temperature for a short period of time after a photocatalytic layer is formed at room temperature, thereby ensuring transparency and low UV dependency to provide super-hydrophilic characteristics in which the coating layer has a surface contact angle of 30 degrees or less.

Another aspect of the present invention is to provide a super-hydrophilic glass coating layer, which has a high pencil hardness of 7 or higher through surface morphology thereof and has high-transmittance super-hydrophilic characteristics.

### [Technical Solution]

In accordance with one aspect of the present invention, a method of improving hydrophilicity of a coating layer through surface morphology treatment includes: forming a photocatalyst layer on a substrate; and heating the substrate having the photocatalyst layer formed thereon to a temperature of 500°C to 600°C to perform post-heat treatment while increasing surface roughness of the photocatalyst layer such that the photocatalyst layer has a surface contact angle of 30 degrees or less.

The forming a photocatalyst layer may be performed by RF magnetron sputtering at room temperature, and the photocatalyst layer may include at least one oxide layer selected from among titanium oxide, silicon oxide, aluminum oxide, iron oxide, silver oxide, copper oxide, tungsten oxide, zinc/tin alloy oxide, zinc titanate, molybdenum oxide, zinc oxide, strontium titanate, cobalt oxide, and chromium oxide layers.

The method may further include forming a barrier layer between the substrate and the photocatalyst layer.

The post heat treatment may be performed for 1 to 10 minutes.

Another aspect of the present invention provides a super-hydrophilic glass coating layer subjected to surface morphology treatment to have a surface roughness (RMS) of 1.5 nm or higher by the method according to the present invention.

The hydrophilic glass coating layer may have a pencil hardness of 7H to 9H.

### [Advantageous Effects]

With the method of improving hydrophilicity of a coating layer through surface morphology treatment according to embodiments of the present invention, the coating layer may exhibit super hydrophilicity of a contact angle of 30 degrees without being influenced by UV irradiation conditions, thereby enabling maintenance of excellent photocatalyst activity.

Further, even after hydrophilic treatment, the coating layer may have high strength characteristics by maintaining surface hardness of 7H or higher.

Thus, the super-hydrophilic glass coating layer according to the present invention may be easily applied to buildings or outdoor advertisement in order to secure a clean outer appearance while facilitating maintenance of the building or outdoor advertisement through natural purification.

### [Description of Drawings]

Fig. 1 is a side-sectional view of a hydrophilic glass coating layer according to one embodiment of the present invention.
Fig. 2 is a graph depicting changes in water contact angle and pencil hardness according to heat treatment temperature in a method of improving hydrophilicity according to the present invention.
Fig. 3 is a graph depicting changes in water contact angle upon UV irradiation according to heat treatment temperature in the method of improving hydrophilicity according to the present invention.
Figs. 4 to 6 are pictures depicting changes in surface roughness due to increase in heat treatment temperature in the method of improving hydrophilicity according to the present invention.
Figs. 7 to 10 are three-dimensional images depicting changes in surface roughness due to increase in heat treatment temperature in the method of improving hydrophilicity according to the present invention.
Fig. 11 is a graph depicting surface roughness according to heat treatment temperature in the method of improving hydrophilicity according to the present invention.

### [Best Mode]

Now, a method of improving hydrophilicity of a coating layer through surface morphology treatment and a super-hydrophilic glass coating layer produced using the same according to the present invention will be described in detail with reference to the accompanying drawings.

The above and other aspects, features, and advantages of the invention will become apparent from the detailed description of the following embodiments in conjunction with the accompanying drawings. It should be understood that the present invention is not limited to the following embodiments and may be embodied in different ways, and that the embodiments are provided for complete disclosure and thorough understanding of the invention by those skilled in the art. The scope of the invention is defined only by the claims. Like components will be denoted by like reference numerals throughout the specification.

A method of improving hydrophilicity of a coating layer through surface morphology treatment according to one embodiment of the present invention includes: forming a photocatalyst layer on a substrate; and heating the substrate having the photocatalyst layer formed thereon to a temperature of 500°C to 600°C to perform post-heat treatment while increasing surface roughness of the photocatalyst layer such that the photocatalyst layer has a surface contact angle of 30 degrees or less.

According to the embodiment of the present invention, the photocatalyst layer is first formed on the substrate for hydrophilic treatment. Here, a vacuum thin film deposition process such as room temperature RF magnetron sputtering is performed to form a large area coating layer having high permeability and a uniform thickness. Here, in particular, the RF magnetron sputtering may be performed at room temperature. Although it is within a general range, room temperature ranges from 18°C to 25°C in the present invention.

Sputtering is generally performed in a temperature range exceeding room temperature, and when the photocatalyst coating layer is formed on the substrate, crystallinity of the photocatalytic material can be obtained but it is difficult to obtain hydrophilic effects.

Further, since production can be conducted only when equipment for heating the substrate is provided to meet high temperature conditions, there are problems of a complex manufacturing process and high manufacturing costs.

According to the present invention, sputtering is performed at room temperature, enabling economical and easy formation of the photocatalyst coating layer, ensuring crystallinity through post-heat treatment and facilitating morphology control through increase in surface roughness while realizing excellent hydrophilicity.

Now, a super-hydrophilic glass coating layer and hydrophiliation conditions according to the present invention will be described.

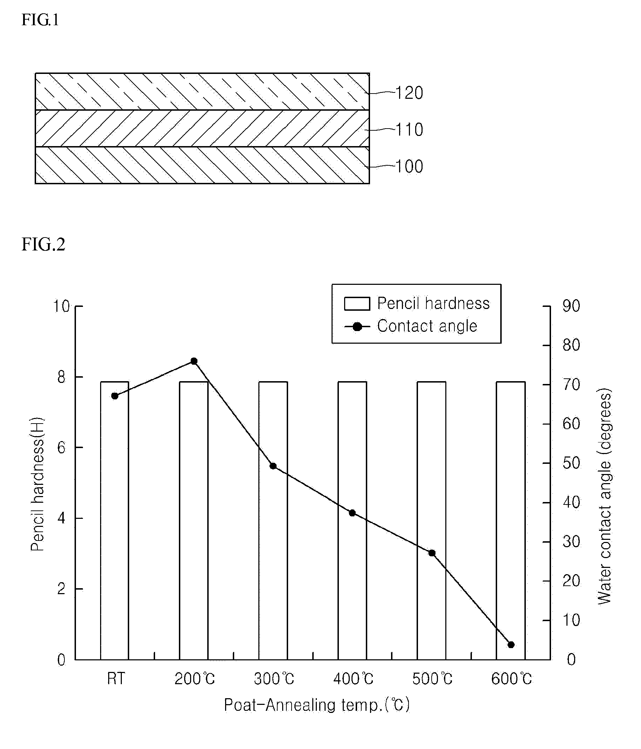

Fig. 1 is a side-sectional view of a hydrophilic glass coating layer according to one embodiment of the present invention.

Referring to Fig. 1, a super-hydrophilic coating layer 120 according to one embodiment of the present invention is formed on a glass substrate 100. Here, a barrier layer 110 may be further formed between the glass substrate 100 and the super-hydrophilic coating layer 120. The barrier layer 110 serves to prevent alkali elements of the glass substrate 100 from diffusing into the super-hydrophilic coating layer 120 to act as impurities over time after coating.

Here, the glass substrate is one example of the substrate in the present invention and may be realized as an interior or exterior component of a vehicle or a window glass product for a building.

The super-hydrophilic coating layer may be comprised of at least one oxide layer selected from among titanium oxide, silicon oxide, aluminum oxide, iron oxide, silver oxide, copper oxide, tungsten oxide, zinc/tin alloy oxide, zinc titanate, molybdenum oxide, zinc oxide, strontium titanate, cobalt oxide, and chromium oxide layers. In some embodiments, a titanium oxide layer may be used as a material for the super-hydrophilic coating layer. Further, at least one of these oxide layers may be used as the barrier layer.

In the present invention, the photocatalyst coating layer of the above structure is formed through RF magnetron sputtering. Here, the super-hydrophilic coating layer 120 may be formed through the following heat treatment process.

In the present invention, heat treatment temperature and heat treatment time are essential factors in improving surface morphology, and it can be seen from the following experimental results that the coating layer exhibits optimal hydrophilicity upon heat treatment in a temperature range from 500°C to 600°C.

First, for an exemplary example of a super-hydrophilic glass coating layer according to the present invention, a soda-lime glass substrate having an area of 100 mm x 100 mm and a thickness of 0.7 t was prepared.

Then, a titanium oxide layer TiO₂ was formed on the soda-lime substrate. Here, the sputtering apparatus was maintained at RF 4.3 W/cm² and a pressure of 3 mtorr was maintained in a 100% argon (Ar) gas atmosphere.

Next, the following experimental results were obtained through heat treatment performed at room temperature (RT), 200°C, 300°C, 400°C, 500°C, and 600°C for five minutes while increasing temperature at a temperature increasing rate of 10°C/min under sintering conditions in an air atmosphere.

Fig. 2 is a graph depicting changes in water contact angle and pencil hardness according to heat treatment temperature in a method of improving hydrophilicity according to the present invention.

First, referring to Fig. 2, it can be seen that the water contact angle was 30 degrees or less in a post-heat treatment temperature range from 500°C to 600°C after formation of the photocatalyst coating layer

In addition, it can be seen that the pencil hardness was maintained at 8 H, that is, within the range of 7H to 9H.

Then, it can be seen that, when heat treatment was performed at a temperature below 500°C, the water contact angle exceeded 30 degrees, causing deterioration in hydrophilic characteristics.

Although not shown in the graph, heat treatment at a temperature exceeding 600°C results in a water contact angle of 30 degrees or more, thereby causing deterioration in hydrophilic characteristics and hardness. Furthermore, heat treatment at a temperature exceeding 700°C can cause deformation of the glass substrate. Accordingly, heat treatment at a temperature exceeding 600°C is not economical.

Thus, considering the surface hardness and hydrophilicity, optimal heat treatment may be performed in a temperature range from 500°C to 600°C.

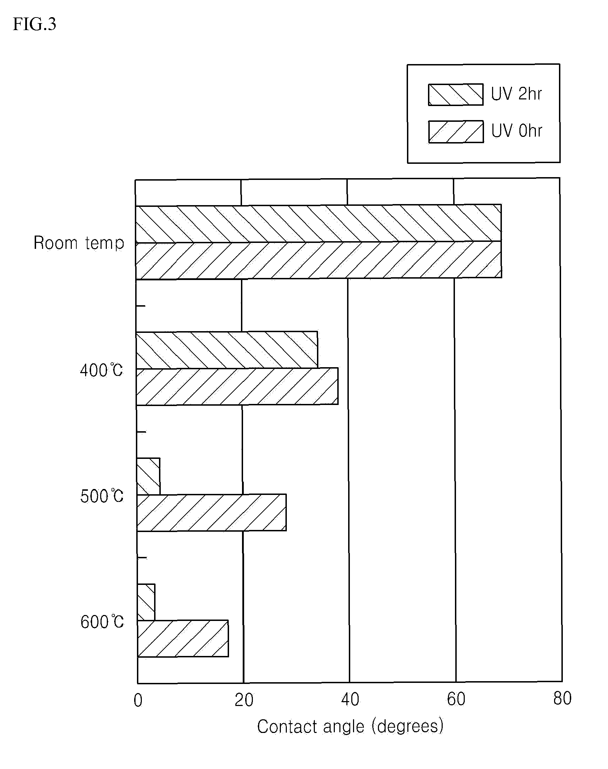

Fig. 3 is a graph depicting changes in water contact angle upon UV irradiation according to heat treatment temperature in the method of improving hydrophilicity according to the present invention.

Referring to Fig. 3, general photocatalytic materials did not provide hydrophilicity under conditions of a short UV irradiation time and low intensity of light.

In the present invention, however, the coating layer exhibits super-hydrophilicity even in interior conditions in which UV light is shielded, through change of surface morphology according to heat treatment temperature, thereby maximizing utilization of existing photocatalysts.

In particular, referring to Fig 3, it can be seen that, when heat treatment was performed at 500°C under conditions according to the present invention, a (water) contact angle was 30 degrees or less. Thus, it can be seen that such surface morphology treatment according to the present invention provides super-hydrophilic characteristics even under an interior condition (UV Ohr) in which UV light is shielded.

As shown in Fig. 3, it can be seen that, since heat treatment at a temperature of less than 500°C resulted in a water contact angle of 30 degrees or more and heat treatment at a temperature exceeding 600°C resulted in a water contact angle of more than 30 degrees, the hydrophilic characteristics were deteriorated.

Referring to Fig. 3, it can be seen that, when UV irradiation duration is adjusted within a range from 1 minute to 2 hours, super hydrophilicity of a contact angle of 10 degrees or less may be realized.

Now, characteristics of a super-hydrophilic glass coating layer according to the present invention will be described with reference to pictures of specimens thereof.

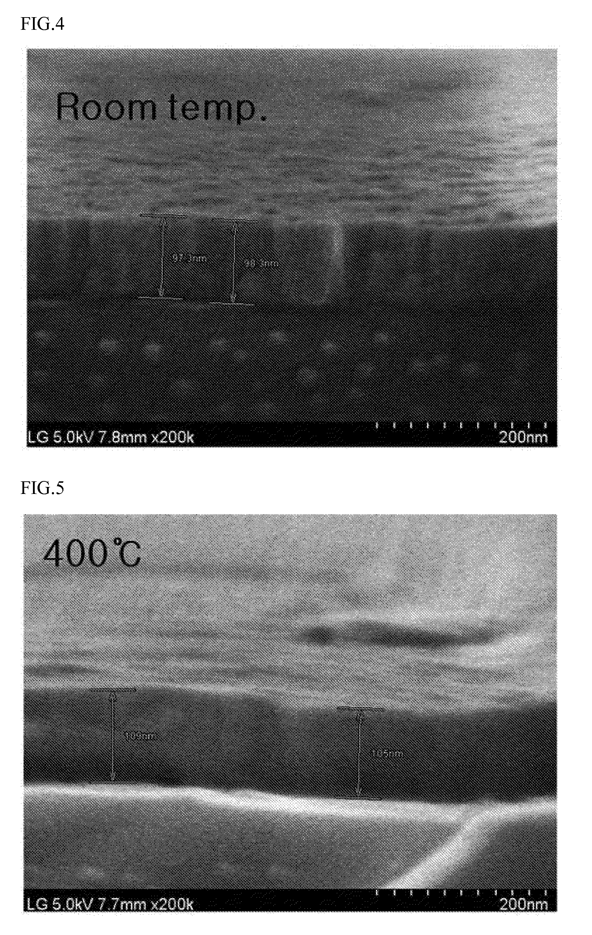

Figs. 4 to 6 are pictures depicting changes in surface roughness due to increase in heat treatment temperature in the method of improving hydrophilicity according to the present invention.

In general, it can be seen that the super-hydrophilic characteristics are observed according to change in surface morphology, and that contact angle decreases with increasing roughness and according to characteristics of a porous structure.

Referring first to Fig. 4, a titanium oxide coating layer not subjected to heat treatment has a thickness of 97.3 nm and 98.3 nm.

Thus, it can be seen that roughness and crystallinity did not substantially appear and hydrophilic characteristics also did not substantially appear.

Next, referring to Fig. 5, it can be seen that, when heat treatment was performed at 400°C, a thickness of 109 nm and 105 nm was obtained over a relatively wide area and the hydrophilic characteristics did not substantially appear.

Although not shown in the figures, it can be seen that, when heat treatment was performed at 700°C, a thickness of less than 100 nm was obtained over a relatively wide area and the hydrophilic characteristics did not substantially appear.

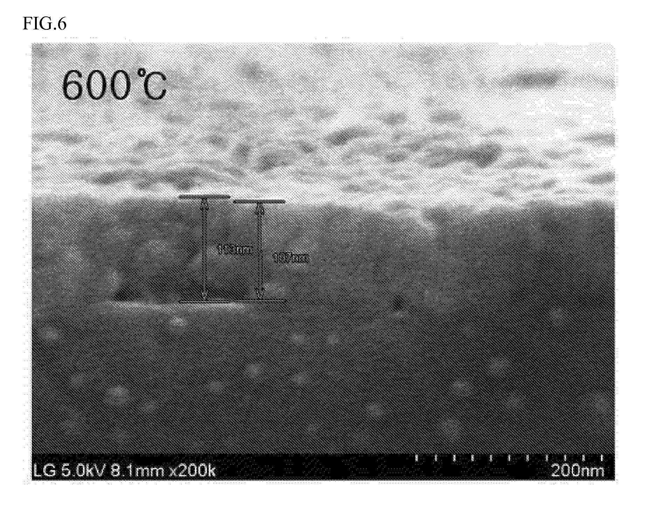

Referring to Fig. 6, it can be seen that, when heat treatment was performed at 600°C under conditions according to the present invention, a thickness of 113 nm and 107 nm was obtained in adjacent areas and surface roughness was high.

Thus, it can be seen that hydrophilic characteristics also appeared high.

In addition, such change in a cross-section will be described with reference to three-dimensional results.

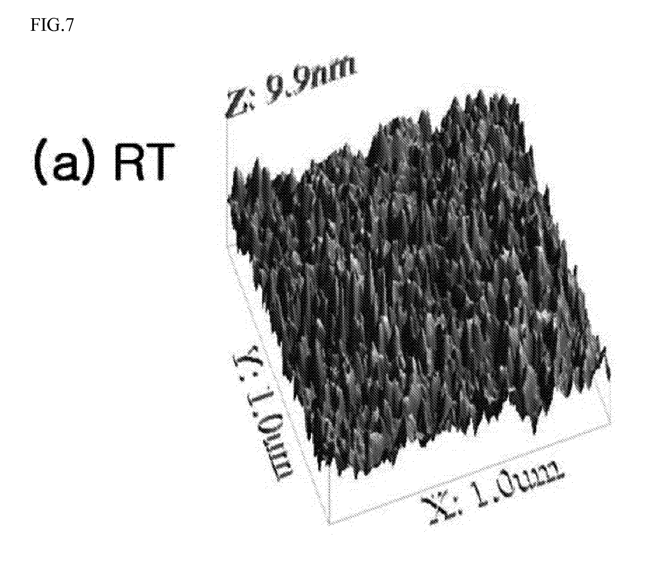

Figs. 7 to 10 are three-dimensional images depicting changes in surface roughness due to increase in heat treatment temperature in the method of improving hydrophilicity according to the present invention.

Fig. 7 shows a result in which heat treatment was not performed at room temperature (RT), and it can be seen that the same results as in Fig. 4 were obtained. That is, it can be seen that surface roughness did not substantially appear and thus hydrophilic effects were deteriorated.

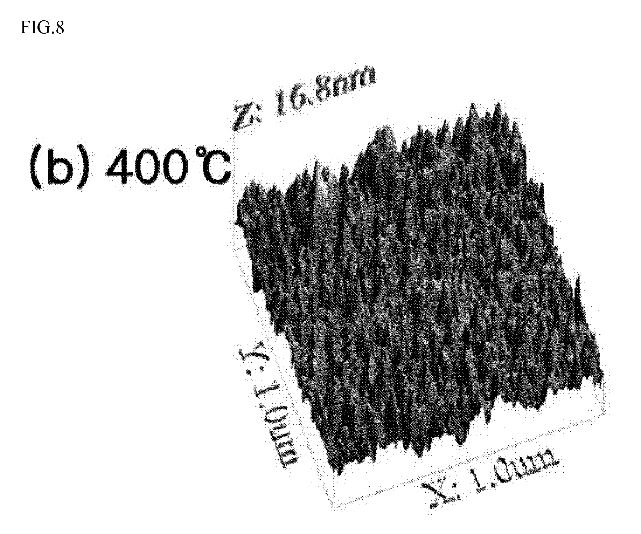

Next, Fig. 8 shows a result in which heat treatment was performed at 400°C, and it can be seen that high surface roughness did not appear and hydrophilicity was deteriorated, irrespective of change in surface morphology. Although not shown in this graph, it can be seen that, when heat treatment was performed at 700°C, high surface roughness did not appear, thereby deteriorating hydrophilicity.

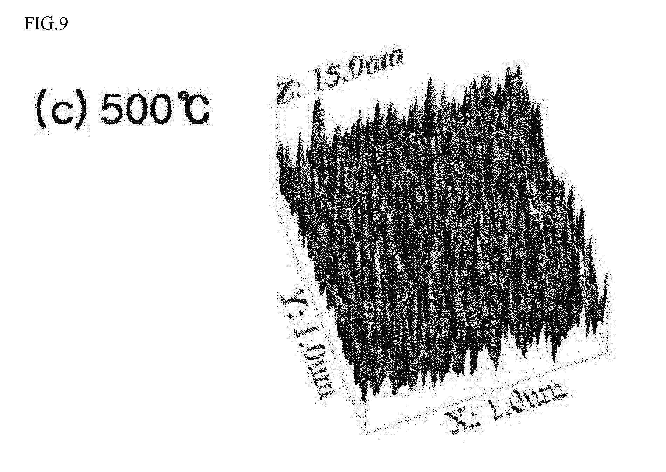

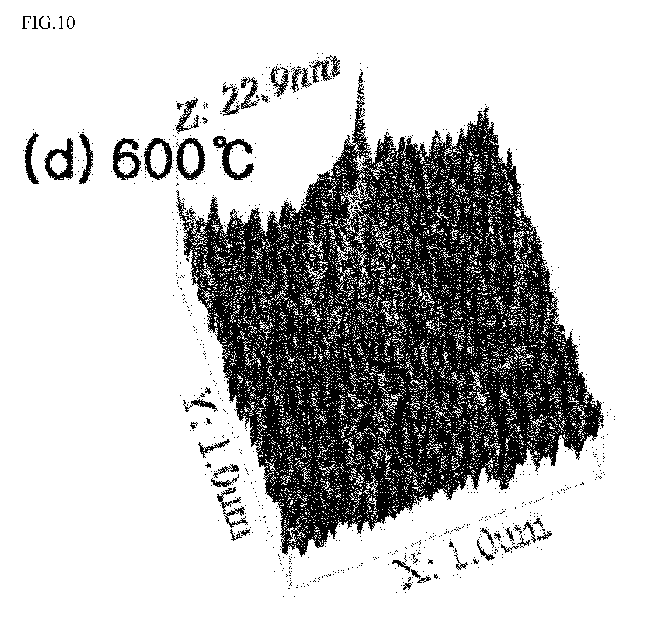

Figs. 9 and 10 show results in which heat treatment was performed at 500°C and 600°C under conditions according to the present invention, and it can be seen that high surface roughness appeared.

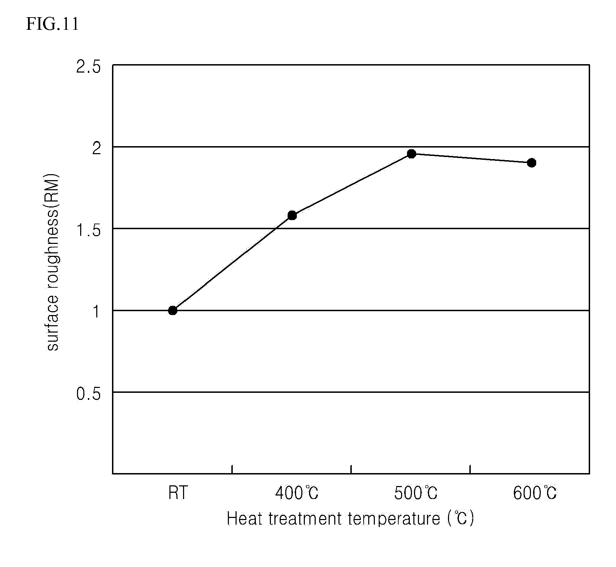

Fig. 11 is a graph depicting surface roughness according to heat treatment temperature in the method of improving hydrophilicity according to the invention.

Fig. 11 is a result in which heat treatment was performed at 500°C and 600°C under conditions according to the present invention, and it can be seen that the super-hydrophilic glass coating layer had a surface roughness (RMS) of 1.5 nm or higher. On the contrary, when heat treatment was performed at a temperature deviating from the temperature range of the present invention, the super-hydrophilic glass coating layer generally had a surface roughness (RMS) of 1.5 nm or less. Referring to Fig. 11, it can be seen that, when heat treatment was performed at 400°C, the super-hydrophilic glass coating layer had a surface roughness (RMS) of 1.5 nm or higher, but did not influence hydrophilicity, and when heat treatment was performed at 700°C, the super-hydrophilic glass coating layer had a surface roughness (RMS) of 1.5 nm or less.

As described above, with the method of improving hydrophilicity of a coating layer through surface morphology treatment according to the embodiments of the present invention, super hydrophilicity of a contact angle of 30 degrees or less may be obtained without being influenced by UV irradiation conditions, while maintaining excellent activity as a photocatalyst.

Further, even after hydrophilic treatment, the coating layer may exhibit high strength by maintaining a surface hardness of 7H or higher.

Thus, the super-hydrophilic glass coating layer according to the present invention may be easily applied to buildings or outdoor advertisements in order to secure a clean outer appearance while facilitating maintenance of the building or outdoor advertisement through natural purification.

Although some embodiments have been described herein, it will be understood by those skilled in the art that these embodiments are provided for illustration only, and various modifications, changes, alterations and equivalent embodiments can be made without departing from the scope of the present invention. Therefore, the scope and sprit of the present invention should be defined only by the accompanying claims and equivalents thereof.

## Claims

1. A method of improving hydrophilicity of a coating layer through surface morphology treatment, comprising:
forming a photocatalyst layer on a substrate; and
heating the substrate having the photocatalyst layer formed thereon to a temperature of 500°C to 600°C to perform post-heat treatment while increasing surface roughness of the photocatalyst layer, such that the photocatalyst layer has a surface contact angle of 30 degrees or less.

2. The method according to claim 1, wherein the forming a photocatalyst layer is performed by room temperature RF magnetron sputtering.

3. The method according to claim 1, wherein the photocatalyst layer comprises at least one oxide layer selected from among titanium oxide, silicon oxide, aluminum oxide, iron oxide, silver oxide, copper oxide, tungsten oxide, zinc/tin alloy oxide, zinc titanate, molybdenum oxide, zinc oxide, strontium titanate, cobalt oxide, and chromium oxide layers.

4. The method according to claim 1, further comprising: forming a barrier layer between the substrate and the photocatalyst layer.

5. The method according to claim 1, wherein the post heat treatment is performed for 1 to 10 minutes.

6. A super-hydrophilic glass coating layer subjected to surface morphology treatment to have a surface roughness (RMS) of 1.5 nm or higher by the method according to any one of claims 1 to 5.

7. The super-hydrophilic glass coating layer according to claim 6, wherein the hydrophilic glass coating layer has a pencil hardness from 7H to 9H.
